(19) Europäisches Patentamt / European Patent Office / Office européen des brevets

(11) **EP 1 610 431 B1**

(12) **EUROPEAN PATENT SPECIFICATION**

(45) Date of publication and mention
of the grant of the patent:
**24.10.2012 Bulletin 2012/43**

(51) Int Cl.:
*H02H 3/40* <sup>(2006.01)</sup>     *G01R 31/08* <sup>(2006.01)</sup>

(21) Application number: **05104896.5**

(22) Date of filing: **06.06.2005**

(54) **Method and system for identifying faulted phase**

Verfahren und Vorrichtung zur Erkennung einer fehlerhaften Phase

Appareil et procédé d'identication d'une phase en défaut

(84) Designated Contracting States:
**DE FR GB IT**

(30) Priority: **23.06.2004 FI 20045238**

(43) Date of publication of application:
**28.12.2005 Bulletin 2005/52**

(73) Proprietor: **ABB Oy**
**00380 Helsinki (FI)**

(72) Inventors:
• **Wahlroos, Ari**
 **65350 Vaasa (FI)**
• **Altonen, Janne**
 **37800 Toijala (FI)**

(74) Representative: **Valkeiskangas, Tapio Lassi Paavali**
**Kolster Oy Ab**
**Iso Roobertinkatu 23**
**P.O. Box 148**
**00121 Helsinki (FI)**

(56) References cited:
**US-A- 4 398 232     US-A- 6 034 592**

**Description**

FIELD OF THE INVENTION

The present invention relates to a method and a system for identifying a faulted phase or phases of a three-phase electricity system in a fault situation.

BACKGROUND OF THE INVENTION

One of the main tasks of all protection systems is to quickly isolate the faulted part from the rest of an electric power system to maintain its stability. A total disconnection of e.g. a transmission or subtransmission line always endangers the stability of one or more power systems. This is because transmission lines transport electric energy between the production and consumption parts of the power systems, and because their disconnection always causes unbalance in the produced and consumed energy in the disconnected parts.

A large majority of line faults on overhead lines, for example, are single-phase-to-earth transient faults, which disappear after a short interruption of power supply. For this reason, single-pole automatic reclosing is introduced into the power systems and if the faulted phase is disconnected for only a short time, the risk of losing the stability of a power system is minimized to the lowest possible level. A reliable phase selection function providing identification of the faulted phase(s), associated with e.g. a distance protection function plays for this reason a very important role and is essential for the correct operation of a fault locator function and distance protection function of a protective relay set. Failure in faulted phase identification very likely results in errors in both functions.

The simplest phase selector functions are based on phase currents only. Their sensitivity is typically limited e.g. by the loading and the fault resistance. Improved sensitivity is obtained, if symmetrical component currents are used or if operation is combined with impedance criteria. Such phase selectors are typically used in distance relays.

One of the drawbacks of current- and impedance-based phase selectors is that they often require several settings. They may, therefore, be difficult for a user to set. The calculation of the correct settings may require great experience and knowledge of the particular system. This applies particularly, if the phase selector uses both current and impedance criteria for the operation.

One example of a method for identifying a faulted phase is disclosed in US 5,783,946. A drawback related to the disclosed solution is that it requires pre-fault data for operation.

BRIEF DESCRIPTION OF THE INVENTION

An object of the present invention is thus to provide a method and an apparatus for implementing the method so as to overcome the above problems or at least to alleviate them. The objects of the invention are achieved by a method and a system, which are characterized by what is stated in the independent claims 1 and 8. Preferred embodiments of the invention are disclosed in the dependent claims.

The invention is based on the idea of using a current and impedance criteria employing ratios of current and impedance values for identifying the faulted phase or phases.

An advantage of the method and system of the invention is that they require only a minimum number of settings, even though both current and impedance operation criteria are used for improved sensitivity. The method and system of the invention are also largely immune to load and system grounding variations, for example, as well as to a decaying DC-component, which could otherwise result in mal-operation or greatly delayed operation of the function.

BRIEF DESCRIPTION OF THE DRAWINGS

In the following, the invention will be described in greater detail by means of preferred embodiments with reference to the attached drawings, in which

Figure 1 is a block diagram illustrating a system according to an embodiment of the invention; and
Figure 2 is a flow diagram illustrating a method according to an embodiment of the invention.

DETAILED DESCRIPTION OF THE INVENTION

The use of the method and system of the invention is not limited to any specific system, but they can be used in connection with various three-phase electric systems to identify a faulted phase or phases in a fault situation. These systems include, for example, electric transmission and distribution networks or components thereof as well as electric power systems and apparatuses. Moreover, the use of the invention is not limited to systems employing 50-Hz or 60-Hz fundamental frequencies.

The invention makes it possible to identify a faulted phase or phases of a three-phase electricity system in a fault situation. In the following, the three phases of the three-phase electricity system to be monitored are referred to as L1, L2, and L3. The invention utilizes values of phase currents $I_{L1}$, $I_{L2}$, and $I_{L3}$ as well as phase voltages $U_{L1}$, $U_{L2}$, and $U_{L3}$ of phases L1, L2, and L3, respectively, which occur during a fault situation. These values are preferably obtained with a suitable measuring arrangement including e.g. current and voltage transducers connected to the phases of the electricity system to be examined. In most existing protection systems, these values are readily available and, thus, the implementation of the invention does not necessary require separate measuring arrangements. How these values are obtained is of no relevance to the basic idea of the invention and depends on the particular electricity system to be monitored. A fault situation of the electricity system to be monitored may be detected by e.g. a protective relay associated with the electricity system.

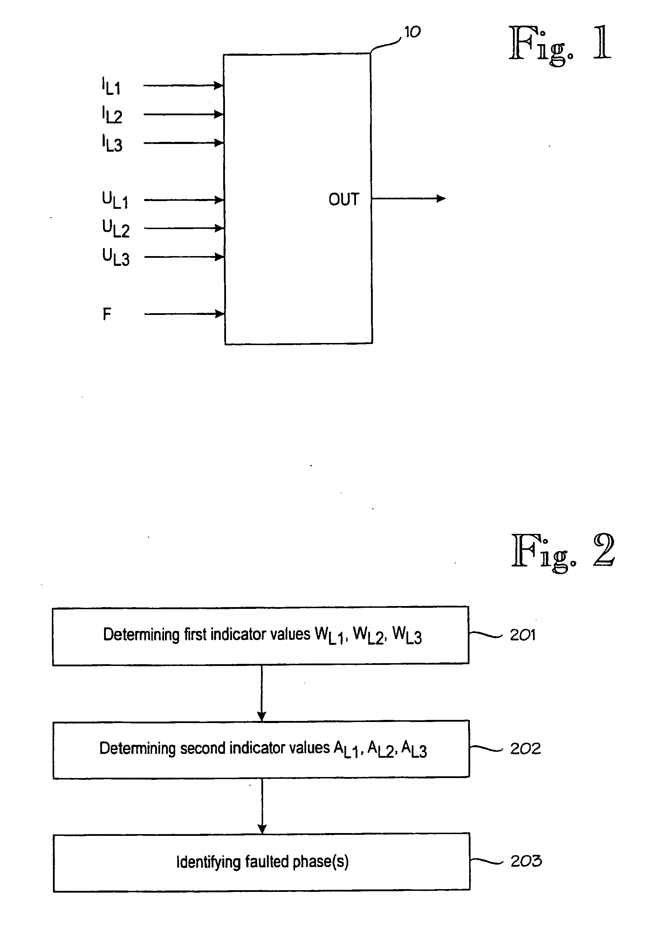

Figure 1 shows a simplified block diagram illustrating the system according to an embodiment of the invention. It should be noted that the invention is by no means limited to the exemplary system shown in Figure 1. The functionality of the invention can be implemented by means of digital signal processing equipment, such as a general-purpose digital signal processor (DSP), with suitable software therein, for example. It is also possible to use a specific integrated circuit or circuits, or corresponding devices. The invention can be implemented in existing system elements, such as various protective relays, or by using separate elements or devices. The system 10 receives current values $I_{L1}$, $I_{L2}$, and $I_{L3}$ as well as voltage values $U_{L1}$, $U_{L2}$, and $U_{L3}$ of phases L1, L2, and L3 of the electricity system (not shown in Figure) to be monitored. In addition the system 10 preferably receives a fault indication signal F, which indicates a fault situation of the electricity system and activates the faulted phase identification. Alternatively the system 10 detects a fault situation independently. This may be implemented such that if any of second indicator values $A_{L1}$, $A_{L2}$, and $A_{L3}$, which are described in more detail later, is below a certain threshold value, preferably 0.6, a fault situation is noted and faulted phase identification is activated. After the faulted phase or phases have been identified, as described in more detail below, corresponding data may be delivered to other systems or equipment, e.g. protective relays, via output OUT.

The faulted phase identification in a fault situation according to the invention is described in the following with reference to the flow diagram of Figure 2. A first indicator value for each of the three phases is determined (201) on the basis of a ratio of a phase current of the phase in question and a negative sequence current component and a ratio of a maximum of phase to earth loop impedances of all the phases and a phase to earth loop impedance of the phase in question. After that a second indicator value is determined (202) for each of the three phases on the basis of a ratio of a maximum of phase currents of all the phases and a phase current of the phase in question and a ratio of a minimum of the first indicator values of all the phases and the first indicator of the phase in question. Finally a phase is identified (203) as faulted if the second indicator value for the phase in question is below a predetermined threshold value T.

The phase to earth loop impedance phasor $\underline{Z}_{Ln}$ of phase Ln (n=1, 2, 3) is preferably determined according to the following formula:

$$\underline{Z}_{Ln} = \underline{U}_{Ln} / \underline{I}_{Ln},$$

where,

$\underline{U}_{Ln}$ = phase voltage phasor of phase Ln, when n=1, 2, 3, and
$\underline{I}_{Ln}$ = phase current phasor of phase Ln, when n=1, 2, 3.

According to an embodiment of the invention, the first indicator values $W_{L1}$, $W_{L2}$, and $W_{L3}$ for the three phases L1, L2, and L3, respectively, are determined according to the following formulas:

$$W_{L1} = \left| \frac{\underline{I}_{L1}}{\underline{I}_2} \right| \cdot \left| \frac{\underline{Z}_{\max PE}}{\underline{Z}_{L1}} \right|,$$

$$W_{L2} = \left| \frac{\underline{I}_{L2}}{\underline{I}_2} \right| \cdot \left| \frac{\underline{Z}_{\max PE}}{\underline{Z}_{L2}} \right|,$$

$$W_{L3} = \left| \frac{\underline{I}_{L3}}{\underline{I}_2} \right| \cdot \left| \frac{\underline{Z}_{\max PE}}{\underline{Z}_{L3}} \right|,$$

where:
$\underline{Z}_{maxPE} = \max(\underline{Z}_{L1}, \underline{Z}_{L2}, \underline{Z}_{L3})$; (maximum phasor of $\underline{Z}_{L1}$, $\underline{Z}_{L2}$ and $\underline{Z}_{L3}$), and
$\underline{I}_2$ = a negative sequence current component phasor
$= \underline{I}_{L1} + \underline{a}^2 \cdot \underline{I}_{L2} + \underline{a} \cdot \underline{I}_{L3}$, where
operator $\underline{a} = 1 \angle 120°$ and $\underline{a}^2 = 1 \angle 240°$.

According to an embodiment of the invention, the second indicator values $A_{L1}$, $A_{L2}$, and $A_{L3}$ for the three phases L1, L2, and L3, respectively, are determined according to the following formulas:

$$A_{L1} = \left| \frac{\underline{I}_{L\max}}{\underline{I}_{L1}} \right| \cdot \frac{W_{L\min}}{W_{L1}},$$

$$A_{L2} = \left| \frac{\underline{I}_{L\max}}{\underline{I}_{L2}} \right| \cdot \frac{W_{L\min}}{W_{L2}},$$

$$A_{L3} = \left| \frac{\underline{I}_{L\max}}{\underline{I}_{L3}} \right| \cdot \frac{W_{L\min}}{W_{L3}},$$

where:
$\underline{I}_{L\max} = \max(\underline{I}_{L1}, \underline{I}_{L2}, \underline{I}_{L3})$; (maximum phasor of $\underline{I}_{L1}$, $\underline{I}_{L2}$ and $\underline{I}_{L3}$), and
$W_{L\min} = \min(W_{L1}, W_{L2}, W_{L3})$.

According to an embodiment of the invention, the predetermined threshold T has a value below 1. The value of the predetermined threshold T is preferably approximately 0.6. The preferable value 0.6 is based on circuit analysis and numerous computer simulations performed by the applicant. The value of threshold T determines the sensitivity of the detection. If the value of the threshold T is selected to be closer to 1, it increases the possibility that a healthy phase is erroneously determined as faulty. Thus, the value of threshold T should be selected in accordance with the sensitivity and other requirements set by the particular electricity system in which the invention is used. According to an embodiment of the invention, if the following comparison for $A_{L1}$, $A_{L2}$, and/or $A_{L3}$ is TRUE, the corresponding phase L1, L2, and/or L3 is faulted:

$A_{L1} < T$,
$A_{L2} < T$,
$A_{L3} < T$.

According to an embodiment of the invention, a three-phase fault is identified if:

$$\left| (\underline{Z}_{maxPE} \cdot \underline{Z}_{maxPE}) \cdot (\underline{Z}_{maxPE} / \underline{Z}_{minPE}) \right| < K_{maxload},$$

where:
$K_{maxload}$ is a predetermined parameter,
$\underline{Z}_{maxPE} = \max(\underline{Z}_{L1}, \underline{Z}_{L2}, \underline{Z}_{L3})$; (maximum phasor of $\underline{Z}_{L1}$, $\underline{Z}_{L2}$ and $\underline{Z}_{L3}$), and
$\underline{Z}_{minPE} = \min(\underline{Z}_{L1}, \underline{Z}_{L2}, \underline{Z}_{L3})$; (minimum phasor of $\underline{Z}_{L1}$, $\underline{Z}_{L2}$ and $\underline{Z}_{L3}$).

The above condition for a three-phase fault preferably overrides earth-fault and short-circuit indications. Parameter $K_{maxload}$ is a setting, which is preferably selected based on maximum load. $K_{maxload}$ is preferably determined according to the following formula:

$$K_{maxload} = (q \cdot Z_{maxload})^2,$$

where
$q < 1$ and preferably 0.8, and
$Z_{maxload} = U_{line}^2 / S_{max}$, where
$U_{line}$ = phase-to-phase voltage [kV],

$S_{max}$ = the maximum loading of the electricity system to be monitored [MVA].

The value of parameter q determines the sensitivity of the criterion. If the value of parameter q is selected to be closer to 1, it increases the possibility that a normal loading situation is erroneously determined as a fault situation. Thus, the value of parameter q should be selected in accordance with the sensitivity and other requirements set by the particular electricity system in which the invention is used. The selected operating variables provide a very sensitive, stable, and secure operation. According to the numerous computer simulations performed by the applicant, the algorithm is very stable and secure. It can typically detect the correct faulted phase at least up to 100 ohm (in 20 kV systems) fault resistances in case of ground faults and 10 ohm (in 20 kV systems) fault resistances in case of short-circuit faults. The invention is easy to implement, as it requires no memory. In addition it is based on phasor magnitudes only and does not require phase angle information.

It will be obvious to a person skilled in the art that, as the technology advances, the inventive concept can be implemented in various ways. The invention and its embodiments are not limited to the examples described above but may vary within the scope of the claims.

## Claims

1. A method for identifying a faulted phase or phases of a three-phase electricity system in a fault situation, **characterized in that** the method comprises:

   a) determining (201) a first indicator value for each of the three phases on the basis of a ratio of a phase current of the phase in question and a negative sequence current component and a ratio of the maximum of phase to earth loop impedances of all the phases and a phase to earth loop impedance of the phase in question;
   b) determining (202) a second indicator value for each of the three phases on the basis of a ratio of the maximum of phase currents of all the phases and a phase current of the phase in question and a ratio of the minimum of the first indicator values of all the phases and the first indicator of the phase in question; and
   c) identifying (203) a phase as faulted if the second indicator value for the phase in question is below a predetermined threshold.

2. A method according to claim 1, **characterized in that** the first indicator values $W_{L1}$, $W_{L2}$, and $W_{L3}$ for the three phases L1, L2, and L3, respectively, are determined (201) according to the following formulas:

$$W_{L1} = \left| \frac{\underline{I}_{L1}}{\underline{I}_2} \right| \cdot \left| \frac{\underline{Z}_{max\,PE}}{\underline{Z}_{L1}} \right|,$$

$$W_{L2} = \left| \frac{\underline{I}_{L2}}{\underline{I}_2} \right| \cdot \left| \frac{\underline{Z}_{max\,PE}}{\underline{Z}_{L2}} \right|,$$

$$W_{L3} = \left| \frac{\underline{I}_{L3}}{\underline{I}_2} \right| \cdot \left| \frac{\underline{Z}_{max\,PE}}{\underline{Z}_{L3}} \right|,$$

where:
$\underline{I}_{Ln}$ = the phase current of phase Ln, when n=1, 2, 3,
$\underline{Z}_{Ln}$ = the phase to earth loop impedance of phase Ln, when n=1, 2, 3,
$I_2$ = the negative sequence current component, and

$$\underline{Z}_{maxPE} = max(\underline{Z}_{L1}, \underline{Z}_{L2}, \underline{Z}_{L3}).$$

3. A method according to claim 2, **characterized in that** the second indicator values $A_{L1}$, $A_{L2}$, and $A_{L3}$ for the three phases L1, L2, and L3, respectively, are determined (202) according to the following formulas:

$$A_{L1} = \left|\frac{\underline{I}_{L\,max}}{\underline{I}_{L1}}\right| \cdot \frac{W_{L\,min}}{W_{L1}},$$

$$A_{L2} = \left|\frac{\underline{I}_{L\,max}}{\underline{I}_{L2}}\right| \cdot \frac{W_{L\,min}}{W_{L2}},$$

$$A_{L3} = \left|\frac{\underline{I}_{L\,max}}{\underline{I}_{L3}}\right| \cdot \frac{W_{L\,min}}{W_{L3}},$$

where:

$$\underline{I}_{Lmax} = \max(\underline{I}_{L1}, \underline{I}_{L2}, \underline{I}_{L3}),$$

and

$$W_{Lmin} = \min(W_{L1}, W_{L2}, W_{L3}).$$

4. A method according to claim 1, 2, or 3, **characterized by** further comprising:

   d) identifying (203) a three-phase fault if:

$$|(\underline{Z}_{maxPE} \cdot \underline{Z}_{maxPE}) \cdot (\underline{Z}_{maxPE} / \underline{Z}_{minPE})| < K_{maxload},$$

   where:
   $K_{maxload}$ is a predetermined parameter,
   $\underline{Z}_{maxPE} = \max(\underline{Z}_{L1}, \underline{Z}_{L2}, \underline{Z}_{L3})$, and
   $\underline{Z}_{minPE} = \min(\underline{Z}_{L1}, \underline{Z}_{L2}, \underline{Z}_{L3})$, where
   $\underline{Z}_{Ln}$ = the phase to earth loop impedance of phase Ln, when n=1, 2, 3.

5. A method according to claim 4, **characterized in that** $K_{maxload}$ is determined according to the following formula:

$$K_{maxload} = (q \cdot Z_{maxload})^2,$$

   where q is approximately 0.8, and

$$Z_{maxload} = U_{line}^2 / S_{max},$$

   where
   $U_{line}$ = the phase-to-phase voltage of the electricity system,
   $S_{max}$ = the maximum loading of the electricity system.

6. A method according to any one of claims 1 to 5, **characterized in that** the phase to earth loop impedance $\underline{Z}_{Ln}$ of phase Ln, when n=1, 2, 3, is determined according to the following formula:

$$\underline{Z}_{Ln} = \underline{U}_{Ln} / \underline{I}_{Ln},$$

where,

$\underline{U}_{Ln}$ = the phase voltage of phase Ln, when n=1, 2, 3, and

$\underline{I}_{Ln}$ = the phase current of phase Ln, when n=1, 2, 3.

7. A method according to any one of claims 1 to 6, **characterized in that** the predetermined threshold has a value of approximately 0.6.

8. A system for identifying a faulted phase or phases of a three-phase electricity system in a fault situation, **characterized in that** the system comprises:

first determination means (10) configured to determine a first indicator value for each of the three phases on the basis of a ratio of a phase current of the phase in question and a negative sequence current component and a ratio of the maximum of phase to earth loop impedances of all the phases and a phase to earth loop impedance of the phase in question;

second determination means (10) configured to determine a second indicator value for each of the three phases on the basis of a ratio of a maximum of phase currents of all the phases and a phase current of the phase in question and a ratio of the minimum of the first indicator values of all the phases and the first indicator of the phase in question; and

identifying means (10) configured to identify a phase as faulted if the second indicator value for the phase in question is below a predetermined threshold.

9. A system according to claim 8, **characterized in that** the first determination means (10) are configured to determine the first indicator values $W_{L1}$, $W_{L2}$, and $W_{L3}$ for the three phases L1, L2, and L3, respectively, according to the following formulas:

$$W_{L1} = \left|\frac{\underline{I}_{L1}}{\underline{I}_2}\right| \cdot \left|\frac{\underline{Z}_{max\,PE}}{\underline{Z}_{L1}}\right|,$$

$$W_{L2} = \left|\frac{\underline{I}_{L2}}{\underline{I}_2}\right| \cdot \left|\frac{\underline{Z}_{max\,PE}}{\underline{Z}_{L2}}\right|,$$

$$W_{L3} = \left|\frac{\underline{I}_{L3}}{\underline{I}_2}\right| \cdot \left|\frac{\underline{Z}_{max\,PE}}{\underline{Z}_{L3}}\right|,$$

where:

$\underline{I}_{Ln}$ = the phase current of phase Ln, when n=1, 2, 3,

$\underline{Z}_{Ln}$ = the phase to earth loop impedance of phase Ln, when n=1, 2, 3,

$\underline{I}_2$ = the negative sequence current component, and

$$\underline{Z}_{maxPE} = \max(\underline{Z}_{L1}, \underline{Z}_{L2}, \underline{Z}_{L3}).$$

10. A system according to claim 9, **characterized in that** the second determination means (10) are configured to determine the second indicator values $A_{L1}$, $A_{L2}$, and $A_{L3}$ for the three phases L1, L2, and L3, respectively, according to the following formulas:

$$A_{L1} = \left|\frac{\underline{I}_{L\,max}}{\underline{I}_{L1}}\right| \cdot \frac{W_{L\,min}}{W_{L1}},$$

$$A_{L2} = \left| \frac{\underline{I}_{L\,max}}{\underline{I}_{L2}} \right| \cdot \frac{W_{L\,min}}{W_{L2}},$$

$$A_{L3} = \left| \frac{\underline{I}_{L\,max}}{\underline{I}_{L3}} \right| \cdot \frac{W_{L\,min}}{W_{L3}},$$

where:

$$\underline{I}_{Lmax} = \max(\underline{I}_{L1}, \underline{I}_{L2}, \underline{I}_{L3}),$$

and

$$W_{Lmin} = \min(W_{L1}, W_{L2}, W_{L3}).$$

11. A system according to claim 8, 9 or 10, **characterized in that** the identifying means (10) are configured to identify a three-phase fault if:

$$|(\underline{Z}_{maxPE} \cdot \underline{Z}_{maxPE}) \cdot (\underline{Z}_{maxPE} / \underline{Z}_{minPE})| < K_{maxload},$$

where:
$K_{maxload}$ is a predetermined parameter,

$$\underline{Z}_{maxPE} = \max(\underline{Z}_{L1}, \underline{Z}_{L2}, \underline{Z}_{L3}),$$

and

$$\underline{Z}_{minPE} = \min(\underline{Z}_{L1}, \underline{Z}_{L2}, \underline{Z}_{L3}),$$

where $\underline{Z}_{Ln}$ = the phase to earth loop impedance of phase Ln, when n=1, 2, 3.

12. A system according to claim 11, **characterized in that** $K_{maxload} = (q \cdot Z_{maxload})^2$, where q is approximately 0.8, and

$$Z_{maxload} = U_{line}^2/S_{max},$$

where
$U_{line}$ = the phase-to-phase voltage of the electricity system,
$S_{max}$ = the maximum loading of the electricity system.

13. A system according to any one of claim 8 to 12, **characterized in that** the phase to earth loop impedance $\underline{Z}_{Ln}$ of phase Ln, when n=1, 2, 3, is determined according to the following formula:

$$\underline{Z}_{Ln} = \underline{U}_{Ln} / \underline{I}_{Ln},$$

where,

$\underline{U}_{Ln}$ = the phase voltage of phase Ln, when n=1, 2, 3, and
$\underline{I}_{Ln}$ = the phase current of phase Ln, when n=1, 2, 3.

**14.** A system according to any one of claims 8 to 13, **characterized in that** the predetermined threshold has a value of approximately 0.6.

**Patentansprüche**

**1.** Ein Verfahren zum Erkennen einer oder mehrerer fehlerhaften Phasen eines dreiphasigen Elektrosystems in einer Ausfallsituation, **dadurch gekennzeichnet, dass** das Verfahren Folgendes aufweist:

a) einen ersten Indikatorwert für jede der drei Phasen auf der Basis eines Verhältnisses von einem Phasenstrom der Phase in Frage zu einer Gegensystemstromkomponente und eines Verhältnisses vom Maximum der Phasenerdschleifenimpedanzen aller Phasen zur Phasenerdschleifenimpedanz der Phase in Frage bestimmen (201);
b) einen zweiten Indikatorwert für jede der drei Phasen auf der Basis eines Verhältnisses vom Maximum der Phasenströme aller Phasen zu einem Phasenstrom der Phase in Frage und eines Verhältnisses vom Minimum der ersten Indikatorwerte aller Phasen zum ersten Indikator der Phase in Fragen bestimmen (202); und
c) eine Phase als fehlerhaft erkennen (203), falls der zweite Indikatorwert für die Phase in Frage unterhalb einem im Voraus bestimmten Schwellenwert liegt.

**2.** Ein Verfahren gemäß dem Patentanspruch 1, **dadurch gekennzeichnet, dass** die ersten Indikatorwerte $W_{L1}$, $W_{L2}$ und $W_{L3}$ für die drei Phasen L1, L2 und L3 jeweils gemäß den folgenden Gleichungen bestimmt (201) werden:

$$W_{L1} = \left| \frac{\underline{I}_{L1}}{\underline{I}_2} \right| \cdot \left| \frac{\underline{Z}_{\max PE}}{\underline{Z}_{L1}} \right|,$$

$$W_{L2} = \left| \frac{\underline{I}_{L2}}{\underline{I}_2} \right| \cdot \left| \frac{\underline{Z}_{\max PE}}{\underline{Z}_{L2}} \right|,$$

$$W_{L3} = \left| \frac{\underline{I}_{L3}}{\underline{I}_2} \right| \cdot \left| \frac{\underline{Z}_{\max PE}}{\underline{Z}_{L3}} \right|,$$

wobei:
$\underline{I}_{Ln}$ = Phasenstrom der Phase Ln, wenn n=1, 2, 3,
$\underline{Z}_{Ln}$ = Phasenerdschleifenimpedanz der Phase Ln, wenn n=1, 2, 3
$\underline{I}_2$ = Gegensystemstromkomponente, und

$$\underline{Z}_{\max PE} = \max(\underline{Z}_{L1}, \underline{Z}_{L2}, \underline{Z}_{L3}).$$

**3.** Ein Verfahren gemäß dem Patentanspruch 2, **dadurch gekennzeichnet, dass** die zweiten Indikatorwerte $A_{L1}$, $A_{L2}$ und $A_{L3}$ für die drei Phasen L1, L2, und L3 gemäß den folgenden Gleichungen bestimmt (202) werden:

$$A_{L1} = \left| \frac{\underline{I}_{L\max}}{\underline{I}_{L1}} \right| \cdot \frac{W_{L\min}}{W_{L1}},$$

$$A_{L2} = \left| \frac{\underline{I}_{L\max}}{\underline{I}_{L2}} \right| \cdot \frac{W_{L\min}}{W_{L2}},$$

$$A_{L3} = \left| \frac{\underline{I}_{L\max}}{\underline{I}_{L3}} \right| \cdot \frac{W_{L\min}}{W_{L3}},$$

wobei:

$$\underline{I}_{L\max} = \max(\underline{I}_{L1}, \underline{I}_{L2}, \underline{I}_{L3}),$$

und

$$W_{L\min} = \min(W_{L1}, W_{L2}, W_{L3}).$$

**4.** Ein Verfahren gemäß dem Patentanspruch 1, 2 oder 3, **dadurch gekennzeichnet, dass** es weiterhin Folgendes aufweist:

d) einen Dreiphasenfehler erkennen (203), wenn:

$$|(\underline{Z}_{\max PE} \cdot \underline{Z}_{\max PE}) \cdot (\underline{Z}_{\max PE} / \underline{Z}_{\min PE})| < K_{\max load},$$

wobei:
$K_{\max load}$ ein im Voraus bestimmter Parameter ist,

$$\underline{Z}_{\max PE} = \max(\underline{Z}_{L1}, \underline{Z}_{L2}, \underline{Z}_{L3}),$$

und

$$\underline{Z}_{\min PE} = \min(\underline{Z}_{L1}, \underline{Z}_{L2}, \underline{Z}_{L3}),$$

wobei
$\underline{Z}_{Ln}$ = Phasenerdschleifenimpedanz der Phase, wenn n=1, 2, 3.

**5.** Ein Verfahren gemäß dem Patentanspruch 4, **dadurch gekennzeichnet, dass** $K_{\max load}$ gemäß der folgenden Gleichung bestimmt wird:

$$K_{\max load} = (q \cdot Z_{\max load})^2,$$

wobei q etwa 0.8 ist, und

$$Z_{\max load} = U_{line}^2 / S_{\max},$$

wobei
$U_{line}$ = Hauptspannung des Elektrosystems,

$S_{max}$ = Maximalbelastung des Elektrosystems.

**6.** Ein Verfahren gemäß einem der Patentansprüche 1 bis 5, **dadurch gekennzeichnet, dass** die Phasenerdschleifenimpedanz $Z_{Ln}$ der Phase Ln, wenn n=1, 2, 3 ist, gemäß der folgenden Gleichung bestimmt wird:

$$\underline{Z}_{Ln} = \underline{U}_{Ln} / \underline{I}_{Ln},$$

wobei,
$\underline{U}_{Ln}$ = Phasenspannung der Phase Ln , wenn n=1, 2, 3, und
$\underline{I}_{Ln}$ = Phasenstrom der Phase Ln, wenn n=1, 2, 3.

**7.** Ein Verfahren gemäß einem der Patentansprüche 1 bis 6, **dadurch gekennzeichnet, dass** der Wert des im Voraus bestimmten Schwellenwertes etwa 0.6 beträgt.

**8.** Ein System zum Erkennen einer oder mehrerer fehlerhaften Phasen eines dreiphasigen Elektrosystems in einer Ausfallssituation, **dadurch gekennzeichnet, dass** das System Folgendes aufweist:

erste Bestimmungsmittel (10) angeordnet, einen ersten Indikatorwert für jede der drei Phasen auf der Basis eines Verhältnisses von einem Phasenstrom der Phase in Frage zu einer Gegensystemstromkomponente und eines Verhältnisses vom Maximum der Phasenerdschleifenimpedanzen aller Phasen zur Phasenerdschleifenimpedanz der Phase in Frage zu bestimmen;
zweite Bestimmungsmittel (10) angeordnet, einen zweiten Indikatorwert für jede der drei Phasen auf der Basis eines Verhältnisses vom Maximum der Phasenströme aller Phasen zu einem Phasenstrom der Phase in Frage und eines Verhältnisses vom Minimum der ersten Indikatorwerte aller Phasen zum ersten Indikator der Phase in Frage zu bestimmen; und
Erkennungsmittel (10) angeordnet, eine Phase als fehlerhaft zu erkennen, falls der zweite Indikatorwert der Phase in Frage unterhalb einem im Voraus bestimmten Schwellenwert liegt.

**9.** Ein System gemäß dem Patentanspruch 8, **dadurch gekennzeichnet, dass** die ersten Bestimmungsmittel (10) angeordnet sind, die ersten Indikatorwerte $W_{L1}$, $W_{L2}$ und $W_{L3}$ für die drei Phasen L1, L2 und L3 jeweils gemäß den folgenden Gleichungen zu bestimmen:

$$W_{L1} = \left| \frac{\underline{I}_{L1}}{\underline{I}_2} \right| \cdot \left| \frac{\underline{Z}_{\max PE}}{\underline{Z}_{L1}} \right|,$$

$$W_{L2} = \left| \frac{\underline{I}_{L2}}{\underline{I}_2} \right| \cdot \left| \frac{\underline{Z}_{\max PE}}{\underline{Z}_{L2}} \right|,$$

$$W_{L3} = \left| \frac{\underline{I}_{L3}}{\underline{I}_2} \right| \cdot \left| \frac{\underline{Z}_{\max PE}}{\underline{Z}_{L3}} \right|,$$

wobei:
$\underline{I}_{Ln}$ = Phasenstrom der Phase Ln, wenn n=1, 2, 3,
$\underline{Z}_{Ln}$ = Phasenerdschleifenimpedanz der Phase Ln, wenn n=1, 2, 3,
$\underline{I}_2$ = Gegensystemstromkomponente, und

$$\underline{Z}_{maxPE} = \max(\underline{Z}_{L1}, \underline{Z}_{L2}, \underline{Z}_{L3}).$$

10. Ein System gemäß dem Patentanspruch 9, **dadurch gekennzeichnet, dass** die zweiten Bestimmungsmittel (10) angeordnet sind, die zweiten Indikatorwerte $A_{L1}$, $A_{L2}$ und $A_{L3}$ für die drei Phasen L1, L2 und L3 jeweils gemäß den folgenden Gleichungen zu bestimmen:

$$A_{L1} = \left| \frac{\underline{I}_{L\max}}{\underline{I}_{L1}} \right| \cdot \frac{W_{L\min}}{W_{L1}} \, ,$$

$$A_{L2} = \left| \frac{\underline{I}_{L\max}}{\underline{I}_{L2}} \right| \cdot \frac{W_{L\min}}{W_{L2}} \, ,$$

$$A_{L3} = \left| \frac{\underline{I}_{L\max}}{\underline{I}_{L3}} \right| \cdot \frac{W_{L\min}}{W_{L3}} \, ,$$

wobei:

$$\underline{I}_{L\max} = \max(\underline{I}_{L1}, \underline{I}_{L2}, \underline{I}_{L3}),$$

und

$$W_{L\min} = \min(W_{L1}, W_{L2}, W_{L3}).$$

11. Ein System gemäß dem Patenanspruch 8, 9 oder 10, **dadurch gekennzeichnet, dass** die Bestimmungsmittel (10) angeordnet sind, einen Dreiphasenfehler zu erkennen, falls:

$$|(\underline{Z}_{maxPE} \cdot \underline{Z}_{maxPE}) \cdot (\underline{Z}_{maxPE} / \underline{Z}_{minPE})| < K_{maxload},$$

wobei:

$K_{maxload}$ ein im Voraus bestimmter Parameter ist,

$$\underline{Z}_{maxPE} = \max(\underline{Z}_{L1}, \underline{Z}_{L2}, \underline{Z}_{L3}),$$

und

$$\underline{Z}_{minPE} = \min(\underline{Z}_{L1}, \underline{Z}_{L2}, \underline{Z}_{L3}),$$

wobei $\underline{Z}_{Ln}$ = Phasenerdschleifenimpedanz der Phase Ln, wenn n=1, 2, 3.

12. Ein System gemäß dem Patentanspruch 11, **dadurch gekennzeichnet, dass** $K_{maxload} = (q \cdot Z_{maxload})^2$, wobei q etwa 0.8 ist, und

$$Z_{maxload} = U_{line}^2 / S_{max},$$

wobei

$U_{line}$ = Hauptspannung des Elektrosystems,

$S_{max}$ = Maximalbelastung des Elektrosystems.

**13.** Ein System gemäß einem der Patentansprüche 8 bis 12, **dadurch gekennzeichnet, dass** die Phasenerdschlei-fenimpedanz $\underline{Z}_{Ln}$ der Phase Ln, wenn n =1, 2, 3 ist, gemäss der folgenden Gleichung bestimmt wird:

$$\underline{Z}_{Ln} = \underline{U}_{Ln} / \underline{I}_{Ln},$$

wobei,

$\underline{U}_{Ln}$ = Phasenspannung der Phase Ln, wenn n=1, 2, 3, und

$\underline{I}_{Ln}$ = Phasenstrom der Phase Ln, wenn n=1, 2, 3.

**14.** Ein System gemäß einem der Patentansprüche 8 bis 13, **dadurch gekennzeichnet, dass** der Wert des im Voraus bestimmten Schwellenwertes etwa 0.6 beträgt.

## Revendications

**1.** Procédé d'identification d'une phase ou de phases en défaut d'un système électrique triphasé dans une situation de défaut, **caractérisé en ce que** le procédé comprend les étapes consistant à :

a) déterminer (201) une première valeur d'indicateur pour chacune des trois phases sur la base d'un rapport d'un courant de phase de la phase en question et d'une composante de courant de séquence négative et d'un rapport du maximum d'impédances de boucle phase à terre de toutes les phases et d'une impédance de boucle phase à terre de la phase en question ;

b) déterminer (202) une seconde valeur d'indicateur pour chacune des trois phases sur la base d'un rapport du maximum de courants de phase de toutes les phases et d'un courant de phase de la phase en question et d'un rapport du minimum des premières valeurs d'indicateur de toutes les phases et du premier indicateur de la phase en question ; et

c) identifier (203) une phase comme phase en défaut si la seconde valeur d'indicateur pour la phase en question est inférieure à un seuil prédéterminé.

**2.** Procédé selon la revendication 1, **caractérisé en ce que** les premières valeurs d'indicateur $W_{L1}$, $W_{L2}$ et $W_{L3}$ respectivement pour les trois phases L1, L2 et L3 sont déterminées (201) selon les formules suivantes :

$$W_{L1} = \left| \frac{\underline{I}_{L1}}{\underline{I}_2} \right| \cdot \left| \frac{\underline{Z}_{max\,PE}}{\underline{Z}_{L1}} \right|,$$

$$W_{L2} = \left| \frac{\underline{I}_{L2}}{\underline{I}_2} \right| \cdot \left| \frac{\underline{Z}_{max\,PE}}{\underline{Z}_{L2}} \right|,$$

$$W_{L3} = \left| \frac{\underline{I}_{L3}}{\underline{I}_2} \right| \cdot \left| \frac{\underline{Z}_{max\,PE}}{\underline{Z}_{L3}} \right|,$$

où :

$\underline{I}_{Ln}$ = le courant de phase de phase Ln, lorsque n = 1, 2, 3,

$\underline{Z}_{Ln}$ = l'impédance de boucle phase à terre de phase Ln, lorsque n = 1, 2, 3,

$\underline{I}_2$ = la composante de courant de séquence négative, et

$$\underline{Z}_{\mathrm{maxPE}} \;=\; \mathtt{max}\,(\underline{Z}_{\mathrm{L1}},\;\;\underline{Z}_{\mathrm{L2}},\;\;\underline{Z}_{\mathrm{L3}})\,.$$

**3.** Procédé selon la revendication 2, **caractérisé en ce que** les secondes valeurs d'indicateur $A_{L1}$, $A_{L2}$ et $A_{L3}$ respectivement pour les trois phases L1, L2 et L3 sont déterminées (202) selon les formules suivantes :

$$A_{L1} = \left| \frac{\underline{I}_{L\,max}}{\underline{I}_{L1}} \right| \cdot \frac{W_{L\,min}}{W_{L1}},$$

$$A_{L2} = \left| \frac{\underline{I}_{L\,max}}{\underline{I}_{L2}} \right| \cdot \frac{W_{L\,min}}{W_{L2}},$$

$$A_{L3} = \left| \frac{\underline{I}_{L\,max}}{\underline{I}_{L3}} \right| \cdot \frac{W_{L\,min}}{W_{L3}},$$

où :

$$\underline{I}_{\mathrm{Lmax}} \;=\; \mathtt{max}\,(\underline{I}_{\mathrm{L1}},\;\;\underline{I}_{\mathrm{L2}},\;\;\underline{I}_{\mathrm{L3}}),$$

et

$$W_{\mathrm{Lmin}} \;=\; \mathtt{min}\,(W_{\mathrm{L1}},\;\;W_{\mathrm{L2}},\;\;W_{\mathrm{L3}})\,.$$

**4.** Procédé selon la revendication 1, 2 ou 3, **caractérisé en ce qu'**il comprend en outre :

    d) l'identification (203) d'un défaut triphasé si :

$$| \,(\underline{Z}_{\mathrm{maxPE}} \cdot \underline{Z}_{\mathrm{maxPE}}) \cdot (\underline{Z}_{\mathrm{maxPE}}/\underline{Z}_{\mathrm{minPE}})\, | < K_{\mathrm{maxload}},$$

où :
$K_{\mathrm{maxload}}$ est un paramètre prédéterminé,

$$\underline{Z}_{\mathrm{maxPE}} \;=\; \mathtt{max}\,(\underline{Z}_{\mathrm{L1}},\;\;\underline{Z}_{\mathrm{L2}},\;\;\underline{Z}_{\mathrm{L3}}),$$

et

$$\underline{Z}_{\mathrm{minPE}} \;=\; \mathtt{min}\,(\underline{Z}_{\mathrm{L1}},\;\;\underline{Z}_{\mathrm{L2}},\;\;\underline{Z}_{\mathrm{L3}}),$$

où
$\underline{Z}_{\mathrm{Ln}}$ = l'impédance de boucle phase à terre de phase Ln, lorsque n = 1, 2, 3.

**5.** Procédé selon la revendication 4, **caractérisé en ce que** $K_{maxload}$ est déterminé selon la formule suivante :

$$K_{maxload} = (q \cdot Z_{maxload})^2,$$

où
q est approximativement de 0,8, et

$$Z_{maxload} = U_{line}^2 / S_{max},$$

où
$U_{line}$ = la tension phase à phase du système électrique,
$S_{max}$ = la charge maximale du système électrique.

**6.** Procédé selon l'une quelconque des revendications 1 à 5, **caractérisé en ce que** l'impédance de boucle phase à terre $\underline{Z}_{Ln}$ de phase Ln, lorsque n = 1, 2, 3, est déterminée selon la formule suivante :

$$\underline{Z}_{Ln} = \underline{U}_{Ln} / \underline{I}_{Ln},$$

où,
$\underline{U}_{Ln}$ = la tension de phase de phase Ln, lorsque n = 1, 2, 3, et
$\underline{I}_{Ln}$ = le courant de phase de phase Ln, lorsque n = 1, 2, 3.

**7.** Procédé selon l'une quelconque des revendications 1 à 6, **caractérisé en ce que** la valeur prédéterminée a une valeur d'approximativement 0,6.

**8.** Système d'identification d'une phase ou de phases en défaut d'un système électrique triphasé dans une situation de défaut, **caractérisé en ce que** le système comprend :

un premier moyen de détermination (10) conçu pour déterminer une première valeur d'indicateur pour chacune des trois phases sur la base d'un rapport d'un courant de phase de la phase en question et d'une composante de courant de séquence négative et d'un rapport du maximum d'impédances de boucle phase à terre de toutes les phases et d'une impédance de boucle phase à terre de la phase en question ;
un second moyen de détermination (10) conçu pour déterminer une seconde valeur d'indicateur pour chacune des trois phases sur la base d'un rapport du maximum de courants de phase de toutes les phases et d'un courant de phase de la phase en question et d'un rapport du minimum des premières valeurs d'indicateur de toutes les phases et du premier indicateur de la phase en question ; et
un moyen d'identification (10) conçu pour identifier une phase comme phase en défaut si la seconde valeur d'indicateur pour la phase en question est inférieure à un seuil prédéterminé.

**9.** Système selon la revendication 8, **caractérisé en ce que** le premier moyen de détermination (10) est conçu pour déterminer les premières valeurs d'indicateur $W_{L1}$, $W_{L2}$ et $W_{L3}$ respectivement pour les trois phases L1, L2 et L3 selon les formules suivantes :

$$W_{L1} = \left| \frac{\underline{I}_{L1}}{\underline{I}_2} \right| \cdot \left| \frac{\underline{Z}_{max\,PE}}{\underline{Z}_{L1}} \right|,$$

$$W_{L2} = \left| \frac{\underline{I}_{L2}}{\underline{I}_2} \right| \cdot \left| \frac{\underline{Z}_{max\,PE}}{\underline{Z}_{L2}} \right|,$$

$$W_{L3} = \left|\frac{\underline{I}_{L3}}{\underline{I}_2}\right| \cdot \left|\frac{\underline{Z}_{maxPE}}{\underline{Z}_{L3}}\right|,$$

où :

$\underline{I}_{Ln}$ = le courant de phase de phase Ln, lorsque n = 1, 2, 3,

$\underline{Z}_{Ln}$ = l'impédance de boucle phase à terre de phase Ln, lorsque n = 1, 2, 3,

$\underline{I}_2$ = la composante de courant de séquence négative, et

$$\underline{Z}_{maxPE} = \max(\underline{Z}_{L1}, \ \underline{Z}_{L2}, \ \underline{Z}_{L3}).$$

**10.** Système selon la revendication 9, **caractérisé en ce que** le second moyen de détermination (10) est conçu pour déterminer les secondes valeurs d'indicateur $A_{L1}$, $A_{L2}$ et $A_{L3}$ respectivement pour les trois phases L1, L2 et L3 selon les formules suivantes :

$$A_{L1} = \left|\frac{\underline{I}_{Lmax}}{\underline{I}_{L1}}\right| \cdot \frac{W_{Lmin}}{W_{L1}},$$

$$A_{L2} = \left|\frac{\underline{I}_{Lmax}}{\underline{I}_{L2}}\right| \cdot \frac{W_{Lmin}}{W_{L2}},$$

$$A_{L3} = \left|\frac{\underline{I}_{Lmax}}{\underline{I}_{L3}}\right| \cdot \frac{W_{Lmin}}{W_{L3}},$$

où :

$$\underline{I}_{Lmax} = \max(\underline{I}_{L1}, \ \underline{I}_{L2}, \ \underline{I}_{L3}),$$

et

$$W_{Lmin} = \min(W_{L1}, \ W_{L2}, \ W_{L3}).$$

**11.** Système selon la revendication 8, 9 ou 10, **caractérisé en ce que** le moyen d'identification (10) est conçu pour identifier un défaut triphasé si :

$$|(\underline{Z}_{maxPE} \cdot \underline{Z}_{maxPE}) \cdot (\underline{Z}_{maxPE}/\underline{Z}_{minPE})| < K_{maxload},$$

où :

$K_{maxload}$ est un paramètre prédéterminé,

$$\underline{Z}_{maxPE} = \max(\underline{Z}_{L1}, \underline{Z}_{L2}, \underline{Z}_{L3}),$$

et

$$\underline{Z}_{minPE} = \min(\underline{Z}_{L1}, \underline{Z}_{L2}, \underline{Z}_{L3}),$$

où
$\underline{Z}_{Ln}$ = l'impédance de boucle phase à terre de phase Ln, lorsque n = 1, 2, 3.

12. Système selon la revendication 11, **caractérisé en ce que** $K_{maxload} = (q \cdot Z_{maxload})^2$, où q est approximativement de 0,8, et

$$Z_{maxload} = U_{line}^2 / S_{max},$$

où
$U_{line}$ = la tension phase à phase du système électrique,
$S_{max}$ = la charge maximale du système électrique.

13. Système selon l'une quelconque des revendications 8 à 12, **caractérisé en ce que** l'impédance de boucle phase à terre $Z_{Ln}$ de phase Ln, lorsque n = 1, 2, 3, est déterminée selon la formule suivante :

$$\underline{Z}_{Ln} = \underline{U}_{Ln} / \underline{I}_{Ln},$$

où,
$\underline{U}_{Ln}$ = la tension de phase de phase Ln, lorsque n = 1, 2, 3, et
$\underline{I}_{Ln}$ = le courant de phase de phase Ln, lorsque n = 1, 2, 3.

14. Système selon l'une quelconque des revendications 8 à 13, **caractérisé en ce que** la valeur prédéterminée a une valeur d'approximativement 0,6.

$I_{L1}$ →

$I_{L2}$ →

$I_{L3}$ →

$U_{L1}$ →

$U_{L2}$ →

$U_{L3}$ →

F →

OUT →

10

# Fig. 1

# Fig. 2

| Determining first indicator values $W_{L1}$, $W_{L2}$, $W_{L3}$ | 201 |

↓

| Determining second indicator values $A_{L1}$, $A_{L2}$, $A_{L3}$ | 202 |

↓

| Identifying faulted phase(s) | 203 |

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5783946 A